# EUROPÄISCHE PATENTSCHRIFT

(11) **EP 1 948 845 B1**
(45) Veröffentlichungstag und Bekanntmachung des Hinweises auf die Patenterteilung: **18.08.2010**
(21) Anmeldenummer: 06830031.8
(22) Anmeldetag: 17.11.2006
(51) Int. Cl.: C23C 16/458

(54) **CVD-REAKTOR MIT GLEITGELAGERTEM SUSZEPTORHALTER**
CVD REACTOR WITH SLIDINGLY MOUNTED SUSCEPTOR HOLDER
REACTEUR DE DEPOT CHIMIQUE EN PHASE VAPEUR A SUPPORT DE SUBSTRAT MONTE COULISSANT

(30) Priorität: 19.11.2005 DE 102005055252
(43) Veröffentlichungstag der Anmeldung: 30.07.2008
(73) Patentinhaber: AIXTRON AG, 52134 Herzogenrath (DE)
(72) Erfinder: FRANKEN, Walter, 52249 Eschweiler (DE); KÄPPELER, Johannes, 52146 Würselen (DE)
(74) Vertreter: Grundmann, Dirk
(86) Internationale Anmeldenummer: PCT/EP2006/068621
(87) Internationale Veröffentlichungsnummer: WO 2007/057443

(56) Entgegenhaltungen:
- EP-A- 1 424 724
- WO-A-00/36635
- US-A1- 2003 188 687

## Beschreibung

Die Erfindung betrifft eine Vorrichtung zum Abscheiden von mindestens einer Schicht auf einem Substrat mit einem oder mehreren Suszeptoren zur Substrataufnahme, mit einem drehantreibbaren Suszeptorhalter, der den Boden einer Prozesskammer bildet, mit einer unterhalb des Suszeptorhalters angeordneten Heizung und einem Gaseinlassorgan zum Einleiten von Prozessgasen in die Prozesskammer.

Eine derartige Vorrichtung ist aus der DE 100 43 600 A1 bekannt. Dort wird ein CVD-Reaktor beschrieben, der in seiner Reaktionskammer eine Prozesskammer aufweist, deren Boden von einem Suszeptorhalter gebildet ist, der in einer Vielzahl von Taschen jeweils von einem Gaslager drehangetriebene Suszeptoren aufweist. Auf jedem dieser kreisscheibenförmigen Suszeptoren liegt ein Substrat, welches in der Prozesskammer beschichtet wird. Die Suszeptoren bzw. der Suszeptorhalter wird von unten mittels RF geheizt. Hierzu befindet sich außerhalb der Prozesskammer in der Reaktorkammer eine HF-Spule. Durch in den Suszeptoren bzw. dem Suszeptorhalter induzierte Wirbelströme entsteht die zum Erreichen der Prozesstemperatur erforderliche Wärme. Die Prozessgase werden über ein Gaseinlassorgan in die Prozesskammer eingeleitet, welches sich im Zentrum der Prozesskammer befindet, so dass sich die Prozessgase in Radialrichtung nach außen bewegen, wo sie von einem Gassammler gesammelt werden. Um die Gasdrehlager mit dem zur Erzeugung des Gaslagers und des Drehimpulses erforderlichen Gas zu versorgen, besitzt der Suszeptorhalter nicht nur Vertikalbohrungen, sondern auch Horizontalbohrungen, da die Gaszuleitung für die Gasdrehlager aus dem Zentrum erfolgt.

Die US 2003/0188687 A1 beschreibt einen ähnlichen Substrathalter. Auch hier soll ein Suszeptorhalter drehbar gelagert sein. Dieser sitzt in einer Lagerausnehmung des Prozesskammerbodens. Er schwebt auf einem Gaslager und ist insofern auch gleitend gelagert. Die gesamte Vorrichtung und insbesondere die Platte zur Aufnahme des Suszeptorhalters ist aber aus Graphit gefertigt, also gerade nicht IR- bzw. RF-durchlässig.

Die US 2005/0051101 A1 beschreibt einen aus einem oberen Teil und einem unteren Teil bestehenden Reaktor. Die beiden Reaktorteile formen zwischen sich eine Kammer, in der ein Substrat liegen soll, welches durch entsprechend geformte Düsen eingebrachtes Gas drehgelagert werden soll. Die US 6,824,619 B1 beschreibt eine ähnliche Vorrichtung.

Die US 6,005,226 beschreibt einen Rapid Thermal Processing-Apparat, bei dem das Substrat entweder auf einem Gaslager oder auf vereinzelten Nadelspitzen gelagert werden soll. Ein Suszeptor zur Substrataufnahme im engeren Sinne ist hier nicht vorgesehen. Die das Substrat tragenden Elemente sind aus Quarz gestaltet.

Die US 5,226,383 beschreibt einen RF-beheizbaren Reaktor, bei dem ein aus Graphit bestehender Suszeptor in einer Aufnahmehöhlung eines aus Graphit bestehenden Suszeptorhalters einliegt.

Die EP 0 519 608 A1 beschreibt einen heizbaren Suszeptorblock, der nicht transparent ist, der eine Höhlung aufbildet, in der ein hoch leitfähiger Suszeptor einliegt.

Die WO 2005/121417 A1 beschreibt einen Suszeptor, der in einer Höhlung eines Suszeptorhalters einliegt. Beide Teile sollen aus Graphit bestehen.

Die EP 1424 724 A1 beschreibt einen CVD-Reaktor mit einem Suszeptor, der von unten beheizt wird. Der Suszeptor ist von einem aus Quarz gefertigten Ring umgeben, der den Suszeptor mittels eines Kugellagers trägt.

Der Erfindung liegt die Aufgabe zugrunde, die gattungsgemäße Vorrichtung gebrauchsvorteilhaft weiterzubilden.

Gelöst wird die Aufgabe durch die in den Ansprüchen angegebene Erfindung.

Der Anspruch 1 sieht zunächst und im Wesentlichen vor, dass der Suszeptorhalter auf einer drehangetriebenen Drehantriebssäule mittels ineinandergreifenden Mitnehmern drehmitgeschleppt wird. Unterhalb der im Wesentlichen IR- und /oder RF-durchlässigen Auflageplatte ist eine IR- und /oder RF-Heizung angeordnet. Der Suszeptor liegt auf einem Gaslager auf. Hierzu ist eine Auflageplatte vorgesehen, die drehfest dem Reaktor zugeordnet ist. Die Auflageplatte liegt ebenso wie der Suszeptorhalter in der Horizontalen, so dass sich eine horizontale Gleitebene ausbildet. Eine Wärmeleitübertragung zwischen Auflageplatte und Suszeptorhalter ist nicht erforderlich, da die Auflageplatte aus einem im Wesentlichen IR- und / oder RF-durchlässigen Material besteht. Zufolge dieser Transparenz gegenüber der zum Aufheizen verwendeten Hochfrequenzstrahlung bzw. dem infraroten Licht heizt sich die Auflageplatte i. W. nicht auf. Die Energie des Lichtes bzw. des Hochfrequenzfeldes gelangt bis in den Suszeptorhalter, der sich in der bekannten Weise aufwärmt. In einer Weiterbildung der Erfindung ist vorgesehen, dass der Suszeptor auf einem Gaslager gleitet. Hierzu können in der Auflageplatte Zuleitungsöffnungen vorgesehen sein, durch die das das Gasgleitlager ausbildende Gas in den Zwischenraum zwischen Auflageplatte und Suszeptorhalter eintreten kann. Es hebt den Suszeptorhalter geringfügig gegenüber der Auflageplatte ab. Während die Auflageplatte drehfest gegenüber dem Reaktor ist, kann sich der Suszeptorhalter drehen. Er wird beispielsweise von einer Drehantriebssäule drehmitgeschleppt. Er kann sich geringfügig in Achsrichtung gegenüber dieser Drehantriebssäule verlagern, so dass sich der Gasspalt zwischen Auflageplatte und Suszeptorhalter einstellen kann. In einer bevorzugten Ausgestaltung der Erfindung liegen die Suszeptoren in Taschen auf Gasdrehlagern. Hierzu sind dem Boden der Taschen Gasaustrittsdüsen zugeordnet, mit denen in bekannter Weise ein Gasdrehlager unterhalb der Suszeptoren erzeugt werden kann. Das durch die Düsen tretende Gas entstammt einem Ringkanal, welcher sich zwischen dem Suszeptorhalter und der Auflageplatte erstreckt. Dieser Ringkanal wird durch eine Durchtrittsöffnung der Auflageplatte mit einem Gas gespeist. Die Auflageplatte kann im Bereich ihrer

Durchtrittsöffnungen auf Kugelflanschen aufliegen, die Gaszuleitungen zugeordnet sind. Die Gaszuleitungen sind Quarzrohre und können durch die Windungen der RF-Spule bzw. einer Heizwicklung ragen. Das Gaseinlassorgan befindet sich im Zentrum der Prozesskammer. Durch das Gaseinlassorgan können in verschiedener Höhe oberhalb des Suszeptorhalters verschiedene Prozessgase in die Prozesskammer eingebracht werden. Die Prozessgase durchströmen die Prozesskammer von innen nach außen in Radialrichtung. Nach oben ist die Prozesskammer durch eine Prozesskammerdecke begrenzt. In einer bevorzugten Ausgestaltung werden die Taschen von einer oder mehreren Abdeckplatten ausgebildet.

Die Zuordnung des Suszeptorhalters zu einer Auflageplatte ermöglicht die Zuleitung eines Gases an verschiedenen Stellen des Suszeptorhalters, insbesondere zur Ausbildung eines Gasdrehlagers für Suszeptoren, ohne dass der Suszeptorhalter in seiner Drehebene verlaufende Kanäle aufweisen muss. Dementsprechend wird die Aufgabe auch dadurch gelöst, dass der Suszeptorhalter gleitend auf einer Auflageplatte liegt, wobei in der Trennebene zwischen Suszeptorhalter und Auflageplatte ein zur Drehachse des Suszeptorhalters konzentrischer Ringkanal ausgebildet ist, in welchen der Auflageplatte zugeordnete Gaseintrittsöffnungen 20, durch welche das Gas in den Ringkanal eingeleitet wird, und dem Suszeptorhalter zugeordnete Gasaustrittsöffnungen, durch welche das Gas aus den der Prozesskammerseite des Suszeptorhalters angeordneten Düsen austreten kann, münden. Wird dieses Gas nicht zum Drehantrieb von Suszeptoren, sondern anderweitig, beispielsweise als Prozessgas verwendet, können die Suszeptoren auch materialeinheitlich mit dem Suszeptorhalter verbunden sein. Die Suszeptoren bilden somit Zonen des Suszeptorhalters aus.

Ein Ausführungsbeispiel der Erfindung wird nachfolgend anhand beigefügter Zeichnungen erläutert. Es zeigen:
- Fig.: 1 einen Querschnitt durch eine im Wesentlichen rotationssymmetrisch ausgestaltete Reaktorkammer und

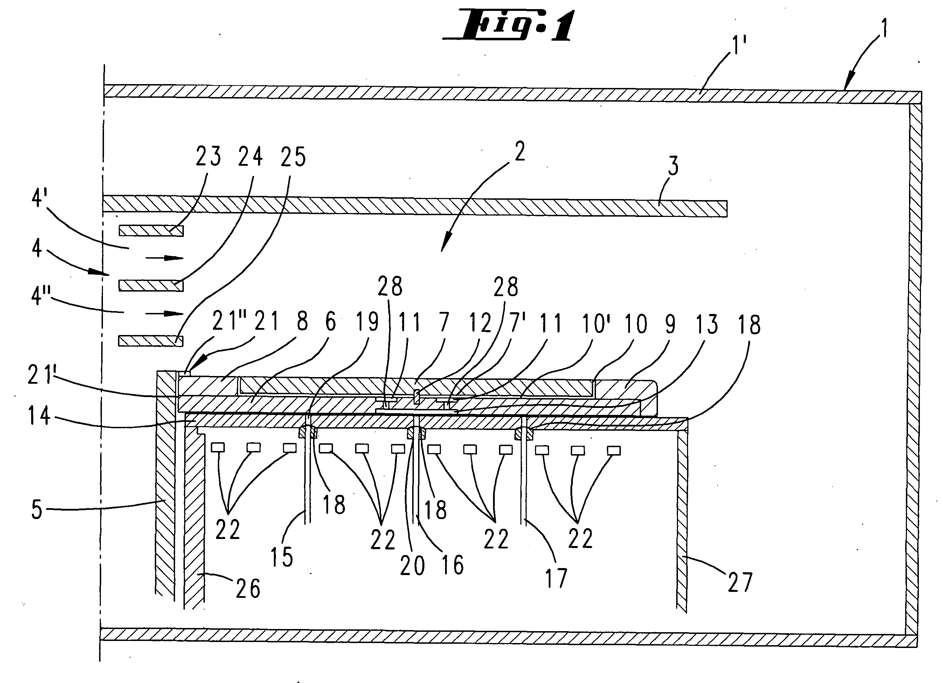

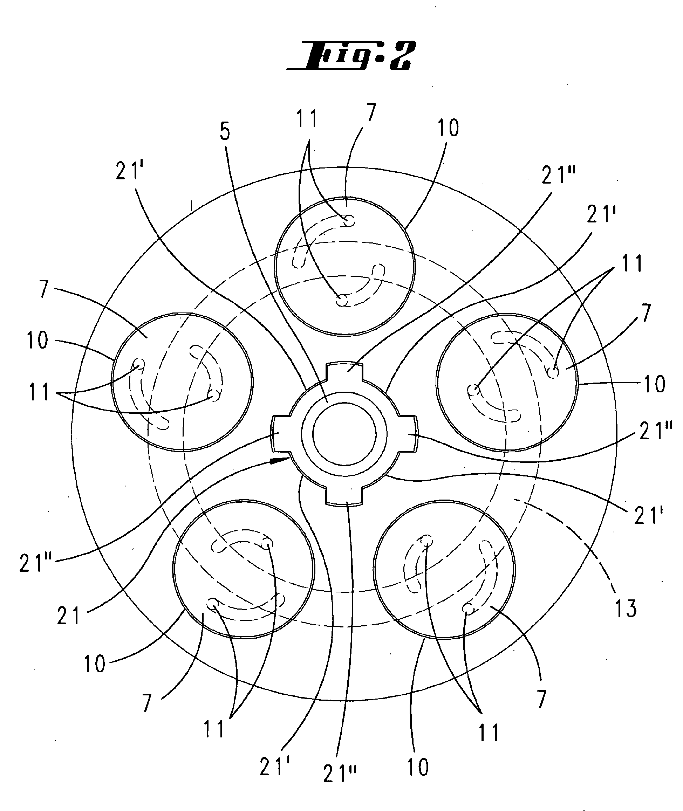

- Fig. 2: den Blick auf den Suszeptorhalter mit den dort in Taschen einliegenden Suszeptoren und den Kopf einer Drehantriebssäule.

Das Ausführungsbeispiel ist ein MOCVD-Reaktor 1. In den Zeichnungen sind nur die zur Erläuterung der Erfindung wesentlichen Bestandteile des Reaktors 1 dargestellt. Die Reaktionskammer des Reaktors 1 wird von einer Reaktorwand 1' gasdicht umschlossen. Innerhalb des Reaktors 1 befindet sich eine Prozesskammer 2, in welcher der CVD-Prozess stattfindet. Nach oben hin wird die sich in Horizontalrichtung erstreckende Prozesskammer 2 von einer Prozesskammerdecke 3 begrenzt. Die Abgrenzung der Prozesskammer 2 nach unten erfolgt durch den Suszeptorhalter 6 mit den darauf aufliegenden Abdeckplatten 8, 9 bzw. Suszeptoren 7.

Hinsichtlich der Einzelheiten des Aufbaus eines derartigen Reaktors 1 wird auf die eingangs genannte DE 100 43 600 A1 verwiesen, die vollinhaltlich mit in diese Anmeldung einbezogen ist.

Die Prozessgase werden mittelst eines Gaseinlassorgans 4 in das Zentrum der Prozesskammer 2 eingeleitet. Dort befinden sich die mit den Bezugsziffern 23, 24, 25 bezeichneten Leitplatten, die horizontale, rotationssymmetrische Gaseinlasskanäle 4', 4" zwischen sich ausbilden. Die Zuleitung der Gase kann von unten oder von oben erfolgen. Hierzu kann ein Gaseinlassorgan verwendet werden, wie es grundsätzlich aus dem Stand der Technik her bekannt ist.,

Mit der Bezugsziffer 5 ist eine Drehantriebssäule bezeichnet. Diese Drehantriebssäule 5 wird über nicht dargestellte Drehantriebsmittel in Drehung versetzt. Diese nicht dargestellten Drehantriebsmittel können sich innerhalb der Reaktorkammer oder auch außerhalb der Reaktorkammer befinden. Wesentlich ist, dass die Drehantriebssäule mit dem Suszeptorhalter 6 drehgekoppelt ist. Der Suszeptorhalter 6 besteht im Wesentlichen aus einer kreisrunden Graphitplatte mit einer zentralen Öffnung. Diese zentrale Öffnung besitzt kreuzartig angeordnete Aussparungen. In diese Aussparungen greifen Mitnehmer 21" der Drehantriebssäule 5 ein. Zwischen diesen Mitnehmern 21" befinden sich Mitnehmer 21' des Suszeptorhalters 6.

Der Suszeptorhalter 6 liegt mit seiner Unterseite auf einer Auflageplatte 14 auf. Die Auflageplatte 14 besteht aus einem Material, welches gegenüber einer Hochfrequenz transparent ist, beispielsweise Quarz.

Unterhalb der Auflageplatte 14 befindet sich eine HF-Heizung in Form einer Flachspule 22. Anstelle der HF-Spule kann auch eine Heizspirale vorgesehen sein. Durch die Windungen der Flachspule 22 ragen in Vertikalrichtung von Quarzrohren gebildete Gaszuleitungen 15, 16, 17. Die Köpfe dieser Gaszuleitungen 15, 16, 17 werden jeweils von einem Kugelflansch 18 ausgebildet. Die Auflageplatte 14 besitzt zu den Kugelflanschen 18 korrespondierende Aufnahmemulden, mit denen die Auflageplatte 14 auf den Kugelflanschen 18 aufliegt. In den Zentren dieser Mulden befinden sich Gasdurchtrittsöffnungen 19, 20, die in den Spaltzwischenraum zwischen der Auflageplatte 14 und dem Suszeptorhalter 6 münden. Die mittlere Gaszuleitung 16 mündet in einen Ringkanal 13, der von einer unterseitigen Nut des Suszeptorhalters 6 ausgebildet wird. Von diesem Ringkanal 13 gehen Gasleitungen 28 aus, die in Antriebsdüsen 11 münden, die auf dem Boden 10' einer Tasche 10 angeordnet sind. Im Zentrum der einen kreisrunden Querschnitt aufweisenden Tasche 10 befindet sich ein Zentrierzapfen 12, um den ein Suszeptor 7 drehgelagert ist. Der Zentrierzapfen 12 ist nicht notwendig, sondern lediglich förderlich.

Der kreisscheibenförmige, ebenfalls aus Graphit bestehende Suszeptor 7 liegt im Betrieb auf einem Gasdrehlager auf. Das Gasdrehlager wird von dem Gas erzeugt, welches durch die Antriebsdüsen 11 austritt. Der die Antriebsdüse 11 mit Gas versorgende Ringkanal 13 wird durch die Gaszuleitung 16 gespeist, die sich unterhalb des Ringkanales 13 befindet. Es können eine Vielzahl derartiger Gaszuleitungen 16 über den gesamten Umfang verteilt vorgesehen sein.

Durch die dem Zentrum der Prozesskammer 2 nahe Gaszuleitung 15 und durch die dem Rand der Prozesskammer 2 nahen Gaszuleitung 17 wird ein Traggas, beispielsweise Wasserstoff in den Spalt zwischen Suszeptorhalter 6 und Auflageplatte 14 eingebracht, welches den Suszeptorhalter geringfügig gegenüber der Auflageplatte 14 anhebt. Hierdurch ist ein Gaslager ausgebildet.

Die oben erwähnten Taschen 10 werden im Ausführungsbeispiel von Abdeckplatten 8, 9 ausgebildet, die flächig auf der Oberseite des Suszeptorhalters 6 aufliegen. Die Dicke dieser Abdeckplatten 8, 9 ist so gewählt, dass im angehobenen Zustand die Oberfläche des Suszeptors 7 mit der Oberfläche der Abdeckplatten 8, 9 fluchtet. Die radial äußere Abdeckplatte 9 besitzt einen abgewinkelten Abschnitt, der den Rand des Suszeptorhalters 6 überfängt.

Die Abdeckplatten 8, 9 sind bevorzugt aus beschichtetem Graphit.

Zufolge der erfindungsgemäßen Ausgestaltung ist eine Versorgung der Taschen 10 mit einem Gas, welches ein Gaslager für den darin einliegenden Suszeptor 7 ausbildet, ohne einen Horizontalkanal innerhalb des Suszeptorhalters 6 möglich. Der Suszeptorhalter besitzt lediglich im Bereich des Ringkanales 13 eine Inhomogenität.

Die Auflageplatte 14 kann auf rohrförmigen Stützkörpern 26, 27 aufliegen, die fest mit dem Gehäuse verbunden sind. Ein erster rohrförmiger Stützkörper 26, der die Drehantriebssäule 5 mit einem geringen Abstand umgibt, lagert den zur zentralen Öffnung hinweisenden Rand der Auflageplatte 14. Ein Stützrohr 27 mit einem größeren Durchmesser lagert im äußeren Rand der Auflageplatte 14. Der in der Prozesskammer 2 durchgeführte Beschichtungsprozess ist ein MOCVD-Process. Hierzu werden die Prozessgase durch die Kanäle 4', 4" des Gaseinlassorganes eingeleitet. Die Kanäle 4', 4" werden von mit Abstand übereinanderliegenden horizontal sich erstreckenden Leitplatten 23, 24, 25 ausgebildet. Die Austrittsöffnungen der Kanäle 4', 4" verlaufen demzufolge auf einer Zylindermantelfläche. Aus der unteren Austrittsöffnung, die dem Kanal 4" zugeordnet ist, kann Arsin, Phosphin oder Ammoniak austreten. Diese Prozessgase können mit Wasserstoff oder Stickstoff als Trägergas verdünnt sein. Aus dem oberen Kanal 4' wird eine metallorganische Verbindung, beispielsweise eine Aluminium-, Gallium- oder Indiumverbindung in die Prozesskammer 2 eingeleitet. Durch eine Oberflächenreaktion auf dem nicht dargestellten Substrat, welches auf dem Suszeptor 7 aufliegt, werden die kristallbildenden Elemente der fünften und dritten Hauptgruppe freigesetzt, um dort als Galliumarsenid oder Galliumnitrit oder ein Mischkristall aufzuwachsen. Die Reaktionsprodukte bzw. nicht verbrauchte Reaktionskomponenten und das Trägergas werden über nicht dargestellte periphere Gassammelorgane abgeleitet. Die Gasableitung kann über eine Vakuumpumpe erfolgen, die ebenfalls nicht dargestellt ist. Die Zuleitung der Prozessgase und auch der Trägergase, die im Zentrum der Prozesskammer in die Prozesskammer 2 eingeleitet werden, erfolgt in Radialrichtung durch ein geeignetes Rohrleitungssystem.

Wie der Fig. 2 zu entnehmen ist, münden die Düsen 11 in insbesondere sich spiralförmig erstreckende Bogennuten, um auf diese Weise ein Drehmoment auf die Suszeptoren auszuüben.

Durch eine geeignete Dimensionierung der Gaszuleitung 16 ist es möglich, auf die weiteren Gaszuleitungen 15,17 zu verzichten. Es braucht dann lediglich ein Gas in den Ringkanal 13 eingebracht zu werden. Die Öffnungen der Antriebsdüsen 11 bilden einen Strömungswiderstand, so dass bei einer geeigneten Dimensionierung des Ringkanals 13 ein Teil des durch die Gaszuleitung 16 eingebrachten Gases nicht durch die Antriebsdüsen 11 strömt, sondern unter die von dem Suszeptorhalter 6 gebildete Platte, so dass diese Platte 6 gegenüber der Auflageplatte 14 angehoben wird, ohne dass an gesonderten Stellen Gas in diesen Spaltzwischenraum eingeleitet wird. Das Gas, welches das Gaslager bildet, tritt aus dem Ringkanal 13 im Wesentlichen in Radialrichtung sowohl nach außen als auch nach innen in den Zwischenraum zwischen dem Suszeptorhalter 6 und der Auflageplatte 14.

## Patentansprüche

1. Vorrichtung zum Abscheiden von mindestens einer Schicht auf einem Substrat mit einem oder mehreren Suszeptoren (7), die jeweils in einer Tasche (10) eines Suszeptorhalters (6) auf einem Gasdrehlager liegen, wobei der von einer kreisförmigen Graphitplatte gebildete Suszeptorhalter (6) den Boden einer Prozesskammer (2) bildet, und mit einem Gaseinlassorgan (4) zum Einleiten von Prozessgasen in die Prozesskammer (2), wobei der Suszeptorhalter (6) drehbar oberhalb einer drehfest der Vorrichtung zugeordneten Auflageplatte (14) liegt, wobei in der Trennebene zwischen Suszeptorhalter (6) und Auflageplatte (14) ein zur Drehachse des Suszeptorhalters (6) konzentrischer Ringkanal (13) ausgebildet ist, in welchen der Auflageplatte (14) zugeordnete Gaseintrittsöffnungen (20) münden und aus welchen das Gas für die Versorgung der Gasdrehlager über dem Suszeptorhalter (6) zugeordnete Gasleitungen (28) kommt, **dadurch gekennzeichnet, dass** der Suszeptorhalter (6) von einer drehangetriebenen Drehantriebssäule mittels ineinandergreifenden Mitnehmern (21', 21 ") auf der Auflageplatte (14) gleitend drehmitgeschleppt wird und unterhalb der im Wesentlichen IR- und/oder RF-durchlässigen Auflageplatte (14) eine IR- oder RF-Heizung angeordnet ist.

2. Vorrichtung nach Anspruch 1, **dadurch gekennzeichnet, dass** der Suszeptorhalter (6) auf einem Gasgleitlager auf der Auflageplatte (14) aufliegt.

3. Vorrichtung nach einem oder mehreren der vorhergehenden Ansprüche, **gekennzeichnet durch** die obere Wandung des Ringkanales (13) mit dem Boden (10') der Tasche (10) verbindende, in Antriebsdüsen (11) mündende Kanäle (28).

4. Vorrichtung nach einem oder mehreren der vorhergehenden Ansprüche, **dadurch gekennzeichnet, dass** die Auflageplatte (14) auf Kugelflanschabschnitten (18) von Gaszuleitungen (15,16, 17) aufliegt.

5. Vorrichtung nach einem oder mehreren der vorhergehenden Ansprüche, **gekennzeichnet durch** auf der zur Prozesskammer (2) weisenden Oberseite des Suszeptorhalters (6) aufliegende Abdeckplatten (8), welche die kreisrunden Taschen (10) zur Aufnahme der Suszeptoren (7) ausbildet.

6. Vorrichtung nach einem oder mehreren der vorhergehenden Ansprüche, **dadurch gekennzeichnet, dass** die Prozesskammer (2) in Radialrichtung von den Prozessgasen durchströmt ist.

7. Vorrichtung nach einem oder mehreren der vorhergehenden Ansprüche, **gekennzeichnet durch** eine gemeinsame Gasversorgung des Gaslagers zur Lagerung des Suszeptorhalters (6) auf der Auflageplatte (14) und zum Drehantrieb der Suszeptoren (7).

8. Vorrichtung nach einem oder mehreren der vorhergehenden Ansprüche, **dadurch gekennzeichnet, dass** die Auflageplatte (14) auf rohrförmigen Stützkörpern (26, 27) aufliegt, die fest mit der Vorrichtung verbunden sind.

9. Vorrichtung nach einem oder mehreren der vorhergehenden Ansprüche, **gekennzeichnet durch** einen rohrförmigen Stützkörper (26), auf welchen die Auflageplatte (14) aufliegt und welcher die Drehantriebssäule (5) mit einem geringen Abstand umgibt.

10. Vorrichtung nach einem oder mehreren der vorhergehenden Ansprüche, **gekennzeichnet durch** die Prozessgase in die Prozesskammer leitende Kanäle (4', 4"), die von mit Abstand übereinanderliegenden horizontal sich erstreckenden Leitplatten (23, 24, 25) im Zentrum der Prozesskammer ausgebildet sind.

## Claims

1. Apparatus for deposition of at least one layer on a substrate, the apparatus comprising one or more susceptors (7), each of which lies on a rotary gas bearing in a pocket (10) of a substrate holder (6), the susceptor holder (6), which is formed by a circular graphite plate, forming the floor of a process chamber (2), and the apparatus comprising a gas inlet member (4) for introducing process gases into the process chamber (2), the susceptor holder (6) lying rotatably above a support plate (14) which is associated with the apparatus in a rotationally fixed manner, an annular channel (13) concentric with the axis of rotation of the susceptor holder (6) being formed in the separation plane between the susceptor holder (6) and the support plate (14), gas inlet openings (20) associated with the support plate (14) opening out into the annular channel and the gas for sustaining the rotary gas bearings coming out of the annular channel by way of gas lines (28) associated with the susceptor holder (6), **characterized in that** the susceptor holder (6) is carried along in a floating manner on the drive plate (14) by a rotary drive column, which is driven in rotation, by means of interengaging drive features (21', 21"), and an IR or RF heater is located underneath the support plate (14), which is substantially transparent to IR and/or RF.

2. Apparatus according to Claim 1, **characterized in that** the susceptor holder (6) is supported on the support plate (14) on a floating gas bearing.

3. Apparatus according to one or more of the preceding claims, **characterized by** channels (28) that open out, through the upper wall of the annular channel (13), into drive nozzles (11), and connect with the base (10') of the pocket (10).

4. Apparatus according to one or more of the preceding claims, **characterized in that** the support plate (14) is supported on spherically-shaped flange portions (18) of gas supply lines (15, 16, 17).

5. Apparatus according to one or more of the preceding claims, **characterized by** cover plates (8) which lie on the upper side of the susceptor holder (6), this side facing the process chamber (2), and the cover plates defining the circular pockets (10) for receiving the susceptors (7).

6. Apparatus according to one or more of the preceding claims, **characterized in that** the process gases flow through the process chamber (2) in the radial direction.

7. Apparatus according to one or more of the preceding claims, **characterized by** a common gas supply to the gas bearing for support of the susceptor holder (6) on the support plate (14) and for rotational drive of the susceptors (7).

8. Apparatus according to one or more of the preceding claims, **characterized in that** the support plate (14) is supported on tubular support bodies (26, 27), which are fixedly connected to the apparatus.

9. Apparatus according to one or more of the preceding claims, **characterized by** a tubular support body (26), on which the support plate (14) is supported and which surrounds the rotary drive column (5) at a small spacing.

10. Apparatus according to one or more of the preceding claims, **characterized by** channels (4', 4") which conduct the process gases into the process chamber and are formed by guide plates (23, 24, 25) that extend horizontally, lying spaced apart one above the other, in the centre of the process chamber.

## Revendications

1. Dispositif de dépôt d'au moins une couche sur un substrat, ledit dispositif comportant un ou plusieurs suscepteurs (7) qui sont placés chacun dans une poche (10) d'un porte-suscepteur (6) disposé sur un coussinet rotatif à gaz, le porte-suscepteur (6) formé par une plaque de graphite de forme circulaire formant le fond d'une chambre de réaction (2), et un organe d'admission de gaz (4) destiné à introduire des gaz de réaction dans la chambre de réaction (2), le porte-suscepteur (6) étant placé de façon à pouvoir tourner au-dessus d'une plaque de support (14) laquelle est immobilisée en rotation par rapport au dispositif, un canal annulaire (13) concentrique à l'axe de rotation du porte-suscepteur (6) étant ménagé dans le plan de séparation entre le porte-suscepteur (6) et la plaque de support (14), canal annulaire dans lequel débouchent des ouvertures d'entrée de gaz (20) associées à la plaque de support (14) et duquel le gaz sort pour alimenter le coussinet rotatif à gaz par le biais de conduites de gaz (28) associées au porte-suscepteur (6),
**caractérisé en ce que** le porte-suscepteur (6) est entraîné en rotation en glissant sur la plaque de support (14) par une colonne d'entraînement en rotation, entraînée en rotation, au moyen d'actionneurs (21', 21") s'engageant l'un dans l'autre et **en ce qu'**un chauffage par ondes infrarouges ou radiofréquences est disposé au-dessous de la plaque de support (14) sensiblement perméable aux ondes infrarouges et radiofréquences.

2. Dispositif selon la revendication 1, **caractérisé en ce que** le porte-suscepteur (6) repose sur un coussinet lisse à gaz sur la plaque de support (14).

3. Dispositif selon l'une ou plusieurs des revendications précédentes, **caractérisé par** des canaux (28) reliant la paroi supérieure du canal annulaire (13) au fond (10') de la poche (10) et débouchant dans des tuyères d'entraînement (11).

4. Dispositif selon l'une ou plusieurs des revendications précédentes, **caractérisé en ce que** la plaque de support (14) repose sur des portions de bride sphériques (18) de conduites d'amenée de gaz (15, 16, 17).

5. Dispositif selon l'une ou plusieurs des revendications précédentes, **caractérisé par** des plaques de recouvrement (8) qui reposent sur le côté supérieur, dirigé vers la chambre de réaction (2), du porte-suscepteur (6) et qui forment les poches circulaires (10) destinées à recevoir les suscepteurs (7).

6. Dispositif selon l'une ou plusieurs des revendications précédentes, **caractérisé en ce que** la chambre de réaction (2) est traversée radialement par les gaz de réaction.

7. Dispositif selon l'une ou plusieurs des revendications précédentes, **caractérisé par** une alimentation en gaz commune du coussinet à gaz destiné à loger le porte-suscepteur (6) sur la plaque de support (14) et à entraîner en rotation les suscepteurs (7).

8. Dispositif selon l'une ou plusieurs des revendications précédentes, **caractérisé en ce que** la plaque de support (14) repose sur des corps de support tubulaires (26, 27) qui sont reliés de façon fixe au dispositif.

9. Dispositif selon l'une ou plusieurs des revendications précédentes, **caractérisé par** un corps de support tubulaire (26) sur lequel repose la plaque de support (14) et qui entoure la colonne d'entraînement en rotation (5) à une faible distance.

10. Dispositif selon l'une ou plusieurs des revendications précédentes, **caractérisé par** des canaux (4', 4") qui conduisent les gaz de réaction jusque dans la chambre de réaction et qui sont formés au centre de la chambre de réaction par des plaques de guidage (23, 24, 25) s'étendant horizontalement à distance l'une au-dessus de l'autre.
